# EUROPEAN PATENT APPLICATION

(11) **EP 1 178 527 A2**
(43) Date of publication of application: **06.02.2002**
(21) Application number: 01118611.1
(22) Date of filing: 02.08.2001
(51) Int. Cl.: H01L 21/311, H01L 21/316, C04B 41/50

(54) **Method for removing silicon carbide from a substrate surface after oxidation**

(30) Priority: 04.08.2000 US 633078
(71) Applicant: Applied Materials, Inc., Santa Clara, California 95054 (US)
(72) Inventor: Han, Felicia (Fei), San Jose, CA 95132 (US); Nemani, Srinivas D, San Jose, California 95136 (US); Venkataraman, Shankar, Santa Clara, CA 95051 (US)
(74) Representative: Kirschner, Klaus Dieter, Dipl.-Phys.

(57) **Abstract**

A method for removing silicon carbide from a substrate. More particularly, a method for removing silicon carbide from a substrate in which the silicon carbide is oxidized to form a silicon oxide, and then the silicon oxide is removed from the substrate.

## Description

The invention generally relates to semiconductor wafer processing equipment and, more particularly, to a method and apparatus for removing silicon carbide from semiconductor substrates.

In the research and development of semiconductor substrate processing equipment and processes, exhaustive process testing often must be performed. The substrates used in such process testing are typically first processed, then cleaned including removal of material deposited during test processing, and then processed again.. This sequence may be repeated many times using the same substrate, thus allowing repetitive testing without wasting large quantities of expensive substrates.. However, the testing requires that certain substrate characteristics, including substrate thickness and surface composition, remain relatively uniform each time the substrate is subjected to test processing. Often, for this reason, before a substrate that has been subjected to test processing can be utilized for additional test processing, material deposited on the substrate must first be removed while leaving the substrate thickness and surface composition substantially similar to that of the substrate before the test processing. Typically, a substrate to be reused after test processing has an average thickness within about 2% of the average thickness of the substrate prior to the test processing.

However, certain types of materials are very difficult to remove from substrates. In particular, silicon carbide is difficult and expensive to remove. Traditional methods of removing material from substrates, such as etching with hydrofluoric acid, are time consuming and costly when used to remove silicon carbide. Moreover, using hydrofluoric acid to etch silicon carbide causes organic polymer formation on the substrates. Such polymer formation changes the surface composition of the substrates and renders the substrates unusable for further test processing. Removing silicon carbide while preserving uniformity of substrate thickness and surface composition is a problem frequently encountered in the microelectronic device fabrication industry.

Therefore, a need exists in the art for an efficient and relatively inexpensive method for removing silicon carbide from substrates.

The present invention provides a method and apparatus for removing silicon carbide from substrates. In particular, the invention provides a method in which silicon carbide on a substrate is oxidized to form a silicon oxide, and then the silicon oxide is removed.

The teachings of the present invention can be readily understood by considering the following detailed description in conjunction with the accompanying drawings, in which:
FIG. 1 shows a block diagram of a system for removing silicon carbide from substrates;
FIG. 2 shows a general process flow diagram for a method of removing silicon carbide from substrates;
FIG. 3 shows a process flow diagram for a first embodiment of the method of FIG. 2; and
Fig. 4 shows a process flow diagram for a second embodiment of the method of FIG. 2.

After considering the following description, those skilled in the art will clearly realize that the teachings of the invention can be readily utilized in removing silicon carbide from semiconductor substrates.

The present invention generally provides a method and apparatus for removing silicon carbide from substrates. In one aspect, silicon carbide on a substrate is oxidized to form a silicon oxide and then the silicon oxide is removed from the substrate. The silicon oxide can be much more readily removed than the silicon carbide using conventional cleaning techniques such as etching using a hydrofluoric acid solution. After the silicon oxide is removed, the substrate is left with a thickness and surface composition substantially similar to that of the substrate prior to the processing leading to the silicon carbide being deposited. Assuming the substrate is being used for test processing purposes, the substrate is, at this point, ready to be reused for additional test processing.

Silicon carbide may be removed from a test substrate many times in this manner, while preserving the necessary consistency with regard to substrate thickness and surface composition required for test processing purposes. For example, the average thickness of the substrate after silicon carbide removal is within 2% of the average thickness of the substrate prior to deposition of the silicon carbide. Thus, a single test substrate may be used repeatedly for test processing, eliminating the need to use large quantities of costly substrates for testing purposes.

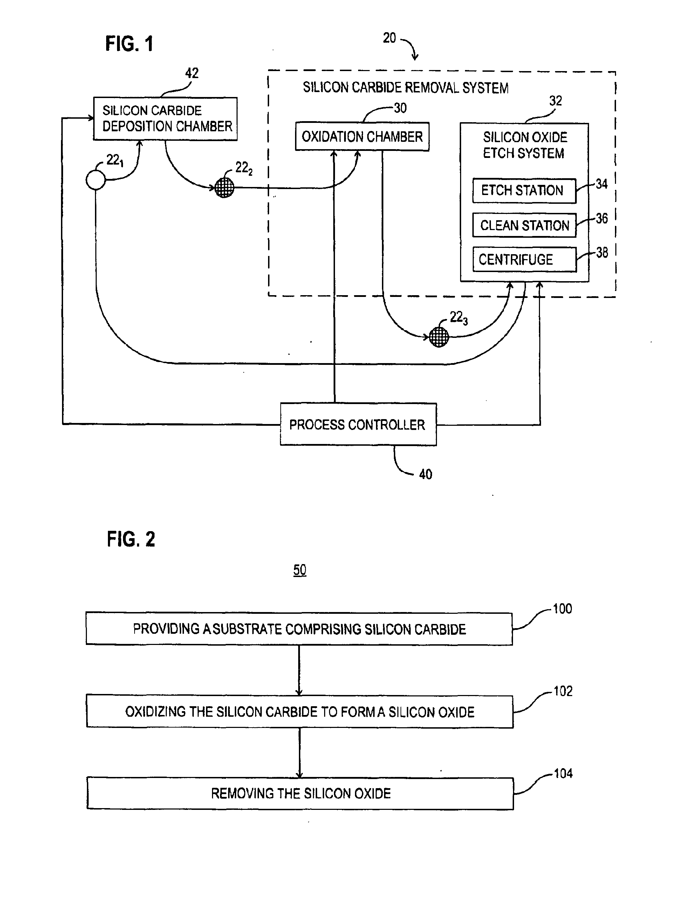

FIG. 1 depicts a block diagram of a system 20 for removing silicon carbide from substrates, where the silicon carbide has been deposited by chamber 42. Generally, the silicon carbide removal system 20 comprises an oxidation chamber 30 and a silicon oxide etch system 32. In one embodiment of the invention, the silicon oxide etch system 32 may comprise an etch station 34, a clean station 36, and a centrifuge 38. After deposition of silicon carbide on a clean substrate 22₁ in a silicon carbide deposition chamber 42, such as a physical vapor deposition chamber or a chemical vapor deposition chamber, the substrate 22₂ (comprising silicon carbide) is transferred to the oxidation chamber 30, where the silicon carbide is oxidized to form a silicon oxide. Next, the substrate 22₃ (comprising silicon oxide) is transferred to the etch station 34. After etching of the silicon oxide in the etch station 34, the substrate is transferred to the clean station 36, where the substrate is cleaned and the etch process is stopped. Finally, the substrate is spin dried in the centrifuge 38. At this point, if the substrate is a test substrate to be reused for additional test processing, the clean substrate 22₁ may be transferred back to the silicon carbide deposition chamber 42.

The process for removing silicon carbide from substrates is preferably controlled by a process controller 40, such as a programmable computer having one or more central processing units (CPUs) and support circuitry containing memory (a computer readable medium) for storing associated control software. A single process controller 40 may be used to control deposition, oxidation, and etching, or multiple process controllers may be used.

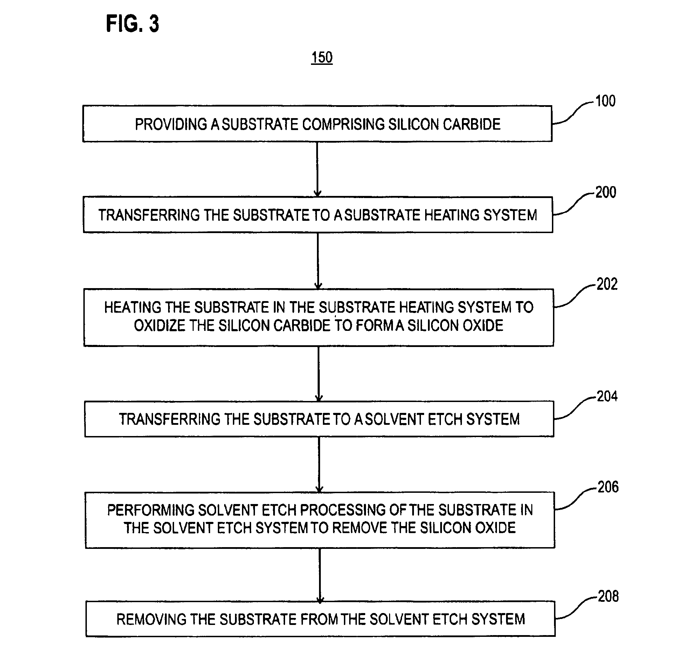

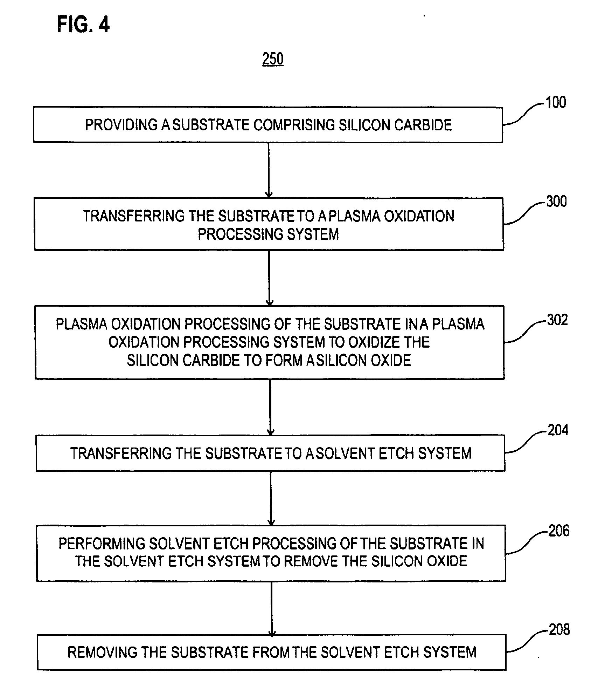

FIG. 2 shows a general process flow diagram for a method 50 of removing silicon carbide from substrates. At step 100, a substrate comprising silicon carbide is provided. For test substrates, the silicon carbide is generally in the form of a layer. However, the silicon carbide could be a feature on the substrate, such as a line, via, plug, pad, or the like. At step 102, the silicon carbide is oxidized to form a silicon oxide. Step 102 can be performed by various processing techniques as discussed below with reference to FIGS. 3 and 4. Finally, at step 104, the silicon oxide is removed. Step 104 may be accomplished by processing techniques as discussed below with reference to FIG. 3.

FIG. 3 shows a process flow diagram for a first embodiment 150 of the method of FIG. 2. At step 100, a substrate comprising silicon carbide is provided. At step 200, the substrate is transferred to a substrate heating system, such as a furnace. The substrate may be transferred by an automated transfer robot, as is commonly known in the art. At step 202, the substrate heating system heats the substrate in an oxygen atmosphere to oxidize the silicon carbide to form a silicon oxide. Typically, the silicon carbide comprises a layer having a thickness of up to about 5kÅ and the silicon oxide comprises a layer having a thickness of up to about 4kÅ. At step 204, the substrate is transferred to a solvent etch system. At step 206, the solvent etch system performs solvent etch processing of the substrate to remove the silicon oxide by immersion of the substrate in a solvent Conventional solvents such as a buffered hydrofluoric acid solution or other fluorine-based solvents may be used. Finally, in step 208, the substrate is removed from the solvent etch system.

### Example process recipe for implementing step 202 of FIG. 3

The following process may be used to implement step 202, wherein the substrate heating system heats the substrate to oxidize silicon carbide to form a silicon oxide. Step 202 may be implemented using a furnace, such as a vacuum furnace, as a heating system. After the substrate has been introduced into the furnace, the temperature of the interior of the furnace is raised to about 650°C, and the pressure kept at atmospheric pressure. Next, nitrogen (N₂) gas is introduced into the furnace at a flow rate of about 7 standard liters per minute (slpm) while the temperature of the interior of the furnace is increased from about 650°C to about 1000°C at the rate of about 10°C to 20°C per minute. After raising the temperature to about 1000°C, the nitrogen flow is stopped and oxygen gas (O₂) is flowed into the furnace at a flow rate of about 2 slpm for about one minute. Next, a hydrogen and oxygen gas mixture is introduced into the furnace by introducing oxygen gas at a flow rate of about 3.5 slpm and hydrogen gas at a flow rate of about 2 slpm.

While flowing the hydrogen and oxygen into the furnace, the substrate is allowed to remain in the 1000°C furnace for from about 20 minutes to about 120 minutes depending on the quantity of silicon carbide to be removed, while the silicon carbide is oxidized to form a silicon oxide. For example, for a substrate having a layer of silicon carbide thereon having a thickness of about 1kÅ, the substrate is heated for about 30 minutes. For a substrate having a silicon carbide layer thereon of about 2kÅ, the substrate is heated for about 45 minutes. For a substrate having a silicon carbide layer thereon of about 4kÅ, the substrate is heated for about 90 minutes. During this process, carbon dioxide and water are formed and exhausted from the furnace. After this, the hydrogen gas flow into the chamber is stopped, and oxygen is introduced into the chamber at a flow rate of about 2 slpm for about one minute. Next, the oxygen flow is stopped and nitrogen gas is introduced into the chamber at a flow rate of about 7 slpm while the temperature is decreased from about 1000°C to about 650°C at the rate of about 10°C to 20°C per minute. Finally, the substrate is removed from the furnace.

The quantities in the above example are variable within certain ranges and depending upon certain factors. For example, the oxidation temperature, which is 1000°C in the above example, may range from about 650°C to about 1050°C. Furthermore, the ratio of introduced hydrogen gas to introduced oxygen gas may vary. However, a liters-of-hydrogen to liters-of-oxygen ratio of between about 2-to-1 and about 1.75-to-1 is preferred. More particularly, if the oxidation process takes place in a vacuum furnace, a liters-of-hydrogen to liters-of-oxygen ratio of about 2-to-1 is preferred.

### Example process recipe for implementing step 206 of FIG. 3

The following process may be used to implement step 206, wherein a solvent etch system performs solvent etch processing on the substrate to remove silicon oxide. The solvent etch system may comprise a hydrofluoric acid bath, a deionized water bath, and a centrifuge. The hydrofluoric acid bath contains a buffered 49% solution of hydrofluoric acid. The substrate is first placed in the hydrofluoric acid bath and allowed to soak in the hydrofluoric acid bath for about 20 minutes to etch any silicon oxide from the substrate. Next, the substrate is immersed in a deionized water bath for about 5 minutes to stop the etch process and clean the substrate. After this, the substrate is spin dried for about 5 minutes in the centrifuge. Finally, the substrate is removed from the solvent etch system (step 208).

Fig. 4 shows a process flow diagram for a second embodiment 250 of the method of FIG. 2. In this embodiment, oxidation of the silicon carbide is achieved through plasma oxidation processing in a plasma oxidation processing system comprising a plasma oxidation processing chamber. At step 100, a substrate comprising silicon carbide is provided. At step 300, the substrate is transferred to a plasma oxidation processing system. The substrate may be transferred by an automated transfer robot, as is commonly known in the art.

At step 302, plasma oxidation processing is performed on the substrate in the plasma oxidation processing chamber of the plasma oxidation processing system to oxidize the silicon carbide to form a silicon oxide. The plasma oxidation processing may utilize a high power RF source (i.e., 500W or greater) to generate a high temperature (i.e., greater than 300°C) plasma from a gas that may comprise fluorine and oxygen.

Solvent etching of the silicon oxide is performed in the same manner as discussed with regard to FIG. 2. Specifically, at step 204, the substrate is transferred to a solvent etch system. At step 206, solvent etching is performed on the substrate to remove the silicon oxide. Finally, in step 208, the substrate is removed from the solvent etch system.

## Claims

1. A method for removing silicon carbide from a substrate, comprising
providing a substrate comprising silicon carbide;
oxidizing the silicon carbide to form a silicon oxide; and
removing the silicon oxide.

2. The method of claim 1, wherein the silicon carbide is a layer, and at least a portion of the silicon oxide layer is removed.

3. The method of claim 1, wherein the silicon carbide is oxidized by heating the substrate in an atmosphere that comprises oxygen.

4. The method of claim 3, wherein the substrate is heated in the presence of a gas mixture comprising hydrogen and oxygen.

5. The method of claim 4, wherein the hydrogen and the oxygen are provided at a ratio of between about 3.5 parts hydrogen to 1 part oxygen by volume and about 2 parts hydrogen to 1 part oxygen by volume, the preferred ration being 2 parts hydrogen to 1 part oxygen by volume and wherein the substrate is heated in a vacuum furnace.

6. The method of claim 1, wherein the silicon carbide is oxidized by heating the substrate in a furnace, preferably in a vacuum furnace.

7. The method of claim 6, wherein the substrate is heated at a temperature in a range of about 650°C to about 1050°C.

8. The method of claim 7, wherein the substrate is heated for from about 20 minutes to about 120 minutes.

9. The method of claim 1, wherein the silicon oxide is removed by a solvent etch process.

10. The method of claim 10, wherein the solvent etch process comprises solvent etch processing using a fluoride solution, preferably a buffered 49% hydrofluoric acid solution.

11. The method of claim 9 or 10, wherein the solvent etch process further comprises rinsing the substrate in de-ionized water and spin drying the substrate in a centrifuge.

12. The method of any of the claims 1 to 5, wherein the silicon carbide is oxidized by performing plasma oxidation processing of the substrate.

13. The method of claim 1, wherein an average thickness of the substrate prior to having the silicon carbide thereon is within about 2% of an average thickness of the substrate after removing at least a portion of the silicon oxide.

14. A system for removing silicon carbide, comprising an oxidation system for oxidizing silicon carbide to form a silicon oxide and an etch system for removing the silicon oxide.

15. The system of claim 14, wherein the etch system comprises an etch station, a clean station; and a centrifuge.

16. The system of claim 14, wherein the oxidation system is a plasma oxidation processing system comprising a plasma oxidation processing chamber, the plasma oxidation processing chamber preferably being part of a plasma oxidation processing system.

17. The system of claim 14, wherein the oxidation system is a heating system, a furnace or a vacuum furnace.
